# EUROPEAN PATENT APPLICATION

(11) **EP 4 465 772 A1**
(43) Date of publication of application: **20.11.2024**
(21) Application number: 23743457.6
(22) Date of filing: 18.01.2023
(51) Int. Cl.: H05K 1/11, H05K 3/42, H05K 3/06, H04M 1/02

(54) **ELECTRONIC DEVICE COMPRISING INTERPOSER AND MANUFACTURING METHOD THEREOF**

(30) Priority: 19.01.2022 KR 20220007691; 25.03.2022 KR 20220037682
(71) Applicant: Samsung Electronics Co., Ltd, Suwon-si, Gyeonggi-do 16677 (KR)
(72) Inventor: CHUNG, Yeonkyung, Suwon-si, Gyeonggi-do 16677 (KR); JEON, Jinhwan, Suwon-si, Gyeonggi-do 16677 (KR); KIM, Jichul, Suwon-si, Gyeonggi-do 16677 (KR); HA, Sangwon, Suwon-si, Gyeonggi-do 16677 (KR)
(74) Representative: Appleyard Lees IP LLP
(86) International application number: PCT/KR2023/000856
(87) International publication number: WO 2023/140610

(57) **Abstract**

An electronic device according to various embodiments of the present disclosure comprises: a housing; and a substrate disposed inside the housing and including a first substrate, a second substrate, and an interposer disposed between the first substrate and the second substrate, wherein a plurality of interposer holes are formed at the interposer, wherein the plurality of interposer holes are filled with a conductor, wherein a nonconductor is disposed on a surface of the interposer between the plurality of interposer holes, and wherein a solder may be disposed at both ends of the conductor. Other various embodiments are possible.

## Description

### [Technical Field]

Various embodiments of the disclosure relate to an electronic device including an interposer.

### [Background Art]

The term "electronic device" may mean a device that performs a specific function according to a program provided therein (e.g., an electronic scheduler, a portable multimedia player, a mobile communication terminal, a tablet PC, an image/sound device, a desktop/laptop PC, or a vehicle navigation system), as well as a home appliance. For example, these electronic devices may output information stored therein as sound or an image. With the increase of degree of integration of electronic devices and the generalization of ultra-high-speed and high-capacity wireless communication, recently, various functions are capable of being installed in a single electronic device, such as a mobile communication terminal. For example, the electronic devices may perform a communication function. These electronic devices are being miniaturized to be conveniently carried by users.

### [Detailed Description of the Invention]

### [Technical Problem]

In order to provide a miniaturized electronic device, the electronic device may include an interposer stacked between adjacent ones of a plurality of substrates. The spacing of holes formed at the interposers is about 0.6 mm, but as the substrates become highly integrated, more holes are required to be formed at the interposers having the same size.

Conventionally, after forming a plurality of holes in a double-sided substrate with a predetermined thickness, plating was performed on the inner walls of the holes to fill the holes with a conductive material, and then plating was performed. However, with this method, it is difficult to form a hole spacing of about 0.4 mm or less. In order to form the hole spacing of about 0.4 mm or less, it is essential to reduce the size of holes and the size of lands, each of which is a portion of the plated portion of each hole.

An inner via hole (IVH) formed by using a drill should be plated on the inner wall of the hole, and the minimum hole forming size for plating is required. For example, in order to ensure the reliability of energization inside the hole while maintaining the hole size to 0.4mm or less, the plating thickness should be about 15µm, and the diameter in drilling size to form such a hole is about 0.15mm. In addition, a space for solder resist disposed between holes is required. Considering these conditions, it may be difficult to implement a hole spacing of 0.4 mm or less.

Various embodiments of the disclosure are able to provide an interposer in which a hole spacing of about 0.4 mm or less is provided such that more holes are provided in an interposer of the same size or the same number of holes are provided in an interposer of a smaller size, and an electronic device including the interposer.

However, the problems to be solved in the disclosure are not limited to the above-mentioned problems, and may be variously expanded without departing from the spirit and scope of the disclosure.

### [Technical Solution]

According to various embodiments of the disclosure, an electronic device may include a housing, and a substrate disposed inside the housing and including a first substrate, a second substrate, and an interposer disposed between the first substrate and the second substrate. A plurality of interposer holes may be formed at the interposer, the plurality of interposer holes may be filled with a conductor, a nonconductor may be disposed on a surface of the interposer between the plurality of interposer holes, and a solder may be disposed on both ends of the conductor.

According to various embodiments of the disclosure, a substrate may include a first substrate, a second substrate, and an interposer disposed between the first substrate and the second substrate. A plurality of interposer holes may be formed at the interposer, the plurality of interposer holes may be filled with a conductor, a nonconductor may be disposed on a surface of the interposer between the plurality of interposer holes, and a solder may be disposed on both ends of the conductor.

According to various embodiments of the disclosure, an interposer manufacturing method may include a process of providing an interposer substrate, wherein a conductor foil is disposed on both surfaces thereof, a process of placing a dry film on a surface of the conductor foil disposed on the both surfaces of the interposer substrate, a process of forming a plurality of interposer holes penetrating the interposer substrate, a process of plating the interposer holes with a conductor, a process of peeling off the dry film, a process of etching to remove the conductor foil to remove at least a portion of the conductor, a process of placing a nonconductor between adjacent ones of the interposer holes, and a process of placing a solder on both ends of the conductor.

### [Advantageous Effects]

According to various embodiments of the disclosure, it is possible to provide an interposer in which more holes are formed in the same size or in which the same number of holes are formed in a smaller size.

According to various embodiments of the disclosure, it is possible to provide an electronic device including an interposer in which more holes are formed in the same size or in which the same number of holes are formed in a smaller size.

### [Brief Description of Drawings]

FIG. 1 is a block diagram illustrating an electronic device in a network environment according to various embodiments of this disclosure.
FIG. 2 is a front perspective view illustrating the electronic device according to various embodiments of the disclosure.
FIG. 3 is a rear perspective view illustrating the electronic device according to various embodiments of the disclosure.
FIG. 4 is an exploded perspective view of the electronic device according to various embodiments of the disclosure.
FIG. 5 is a bottom view of an electronic device according to various embodiments of the disclosure, in which a rear surface plate is removed.
FIG. 6 is an exploded perspective view of the electronic device according to various embodiments of the disclosure.

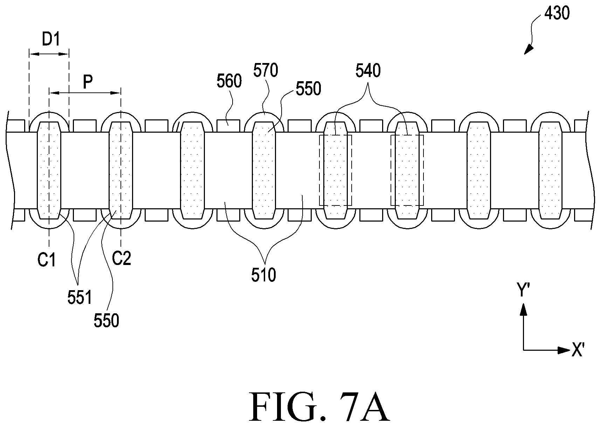

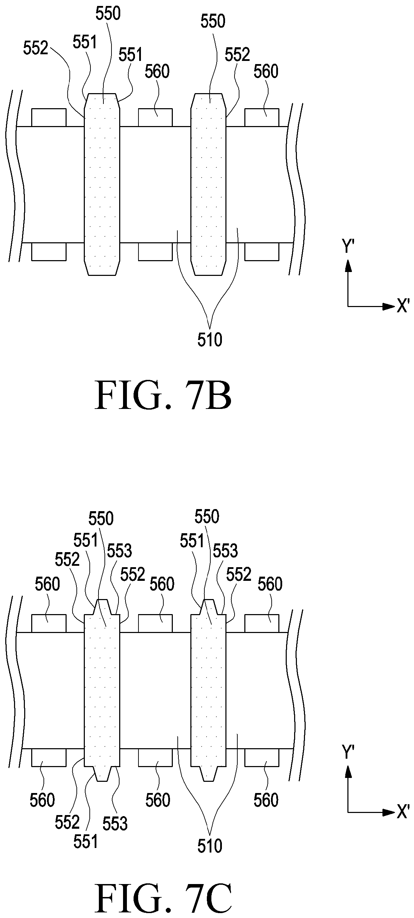

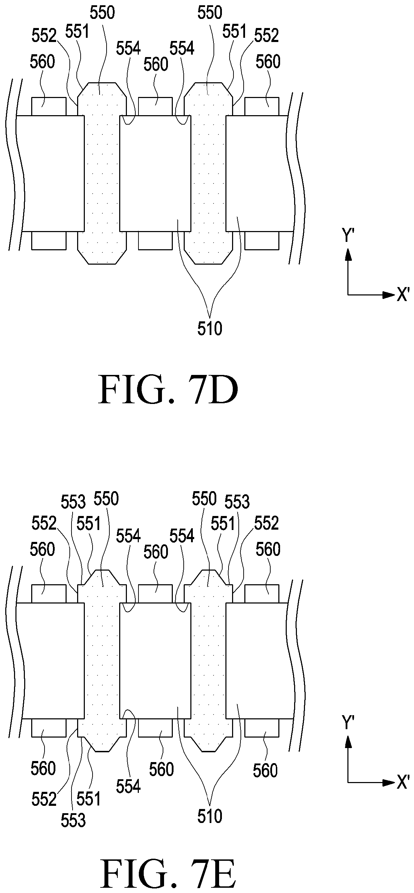

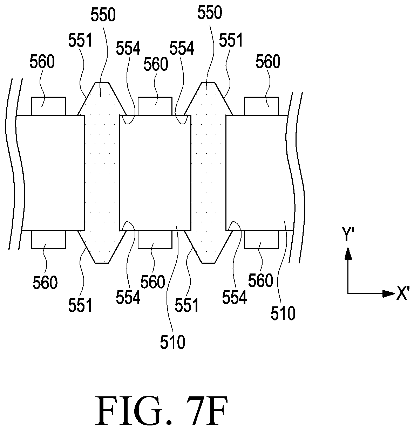

FIG. 7A is a cross-sectional view of an interposer according to various embodiments of the disclosure, FIG. 7B is a cross-sectional view of an interposer according to another embodiment of the disclosure, FIG. 7C is a cross-sectional view of an interposer according to another embodiment of the disclosure, FIG. 7D is a cross-sectional view of an interposer according to another embodiment of the disclosure, FIG. 7E is a cross-sectional view of an interposer according to another embodiment of the disclosure, and FIG. 7F is a cross-sectional view of an interposer according to another embodiment of the disclosure.
FIGS. 8A and 8B are a schematic view and a flowchart of a process for manufacturing an interposer, according to various embodiments of the disclosure.

### [Mode for Carrying out the Invention]

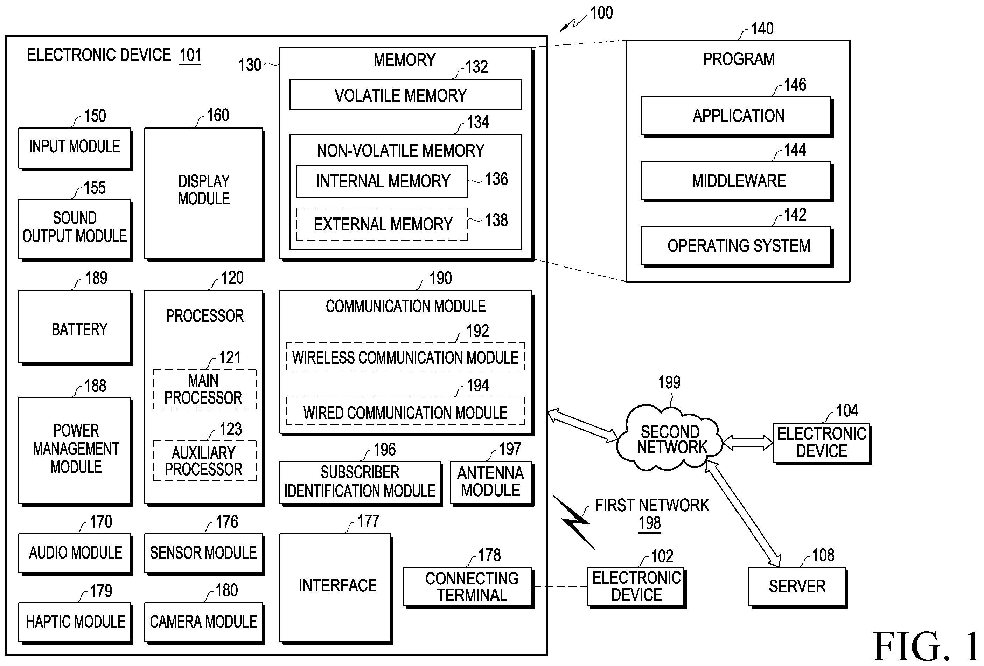

FIG. 1 is a block diagram illustrating an electronic device in a network environment according to various embodiments of this disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160). The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

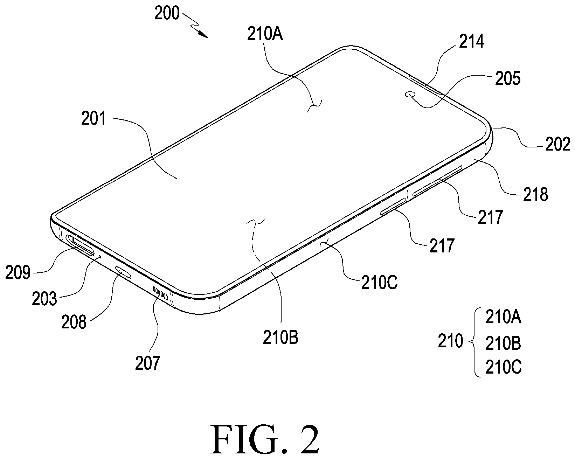

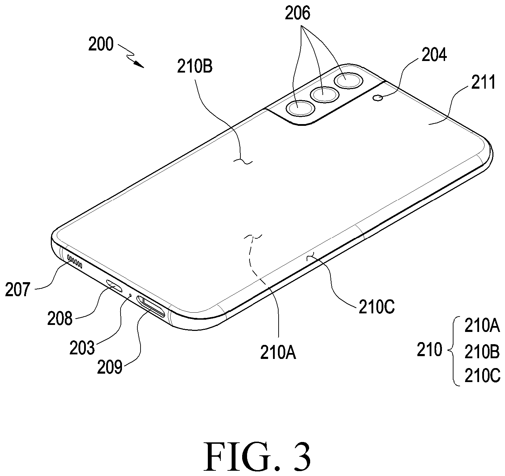

FIG. 2 is a front perspective view illustrating an electronic device 200 according to various embodiments of the disclosure. FIG. 3 is a rear perspective view illustrating the electronic device 200 according to various embodiments of the disclosure.

Referring to FIGS. 2 and 3, the portable electronic device 200 according to an embodiment may include a housing 210 including a front surface 210A, a rear surface 210B, and a side surface 210C surrounding the space between the front surface 210A and the rear surface 210B. According to another embodiment (not illustrated), the term "housing 210" may refer to a structure defining some of the front surface 210A of FIG. 2, and the rear surface 210B and the side surface 210C of FIG. 3. According to an embodiment, at least a portion of the front surface 210A may be defined by a substantially transparent front surface plate 202 (e.g., a glass plate or a polymer plate including various coating layers). The rear surface 210B may be provided by the rear surface plate 211. The rear surface plate 211 may be made of, for example, glass, ceramic, polymer, metal (e.g., aluminum, stainless steel (STS), or magnesium), or a combination of two or more of these materials. The side surface 210C may be defined by a side surface bezel structure (or a "side surface member") 218 coupled to the front surface plate 202 and the rear surface plate 211 and including metal and/or polymer. According to an embodiment, the rear surface plate 211 and the side surface bezel structure 218 may be configured integrally with each other and may include the same material (e.g., glass, a metal material such as aluminum, or ceramic). According to another embodiment, the front surface 210A and/or the front surface plate 202 may be interpreted as a part of the display 201.

According to an embodiment, the electronic device 200 may include at least one of a display 201, an audio module 203, 207, or 214 (e.g., the audio module 170 in FIG. 1), a sensor module (e.g., the sensor module 176 in FIG. 1), a camera module 205 or 206 (e.g., the camera module 180 in FIG. 1), a key input device 217 (e.g., the input module 150 in FIG. 1), and a connector hole 208 or 209 (e.g., the connection terminal 178 in FIG. 1). In some embodiments, in the electronic device 200, at least one of the components (e.g., the connector hole 209) may be omitted, or other components may be additionally included. According to an embodiment, the display 201 may be visually exposed through a substantial portion of, for example, the front surface plate 202.

According to an embodiment, the surface of the housing 210 (or the front surface plate 202) may include a screen display area provided since the display 201 is visually exposed. For example, the screen display area may include the front surface 210A.

According to another embodiment (not illustrated), the electronic device 200 may include a recess or opening provided in a portion of the screen display area (e.g., the front surface 210A) of the display 201, and may include at least one of an audio module 214, a sensor module (not illustrated), a light-emitting element (not illustrated), and a camera module 205 aligned with the recess or opening. According to another embodiment (not illustrated), the rear surface of the screen display area of the display 201 may include at least one of an audio module 214, a sensor module (not illustrated), a camera module 205, a fingerprint sensor (not illustrated), and a light-emitting element (not illustrated).

According to another embodiment (not illustrated), the display 201 may be coupled to or disposed adjacent to a touch-sensitive circuit, a pressure sensor capable of measuring a touch intensity (pressure), and/or a digitizer configured to detect an electromagnetic field-type stylus pen.

According to an embodiment, at least a portion of the key input device 217 may be disposed on the side bezel structure 218.

According to an embodiment, the audio modules 203, 207, and 214 may include, for example, a microphone hole 203 and speaker holes 207 and 214. The microphone hole 203 may include a microphone disposed therein to acquire external sound, and in some embodiments, a plurality of microphones may be disposed therein to be able to detect the direction of sound. The speaker holes 207 and 214 may include an external speaker hole 207 and a communication receiver hole 214. In some embodiments, the speaker holes 207 and 214 and the microphone hole 203 may be implemented as a single hole, or a speaker (e.g., a piezo speaker) may be included without the speaker holes 207 and 214.

According to an embodiment, the sensor module (not illustrated) may generate, for example, an electrical signal or a data valuecorresponding to an internal operating state or an external environmental state of the electronic device 200. The sensor module (not illustrated) may include, for example, a first sensor module (not illustrated) (e.g., a proximity sensor) and/or a second sensor module (not illustrated) (e.g., fingerprint sensor) disposed on the front surface 210A of the housing 210. The sensor module (not illustrated) may include a third sensor module (not illustrated) (e.g., an HRM sensor) and/or a fourth sensor module (not illustrated) (e.g., a fingerprint sensor) disposed on the rear surface 210B of the housing 210. According to another embodiment (not illustrated), the fingerprint sensor may be disposed not only on the front surface 210A (e.g., the display 201) of the housing 210, but also on the rear surface 210B. The electronic device 200 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor (not illustrated).

According to an embodiment, the camera modules 205 and 206 (e.g., under-display cameras (UDCs) may include, for example, a front camera module 205 disposed on the front surface 210A of the electronic device 200, a rear camera module 206 disposed on the rear surface 210B, and/or a flash 204. The camera modules 205 and 206 may include one or more lenses, an image sensor, and/or an image signal processor. The flash 204 may include, for example, a light-emitting diode or a xenon lamp. According to an embodiment, two or more lenses (e.g., an infrared camera lens, a wide-angle lens, and a telephoto lens) and image sensors may be disposed on one surface of the electronic device 200.

According to an embodiment, the key input device 217 may be disposed on the side surface 210C of the housing 210. According to another embodiment, the electronic device 200 may not include some or all of the above-mentioned key input devices 217, and the key input devices 217, which are not included in the electronic device 201, may be implemented in another form, such as soft keys, on the display 201.

According to an embodiment, the light-emitting element (not illustrated) may be disposed on, for example, the front surface 210A of the housing 210. The light-emitting element (not illustrated) may provide, for example, the state information of the electronic device 200 in an optical form. According to another embodiment, the light-emitting element (not illustrated) may provide a light source that is interlocked with, for example, the operation of the front camera module 205. The light-emitting element (not illustrated) may include, for example, an LED, an IR LED, and/or a xenon lamp.

According to an embodiment, the connector holes 208 and 209 may include, for example, a first connector hole 208 capable of accommodating a connector (e.g., a USB connector) configured to transmit/receive power or an audio signal and/or data to/from an external electronic device, and/or a second connector hole 209 capable of accommodating a storage device (e.g., a subscriber identification module (SIM) card). According to an embodiment, the first connector hole 208 and/or the second connector hole 209 may be omitted.

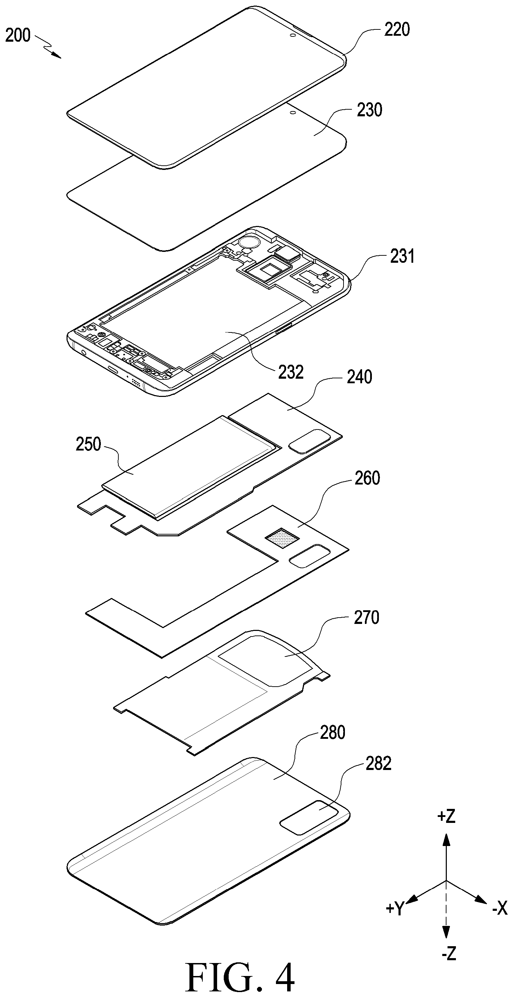

FIG. 4 is an exploded perspective view of the electronic device according to various embodiments of the disclosure.

Referring to FIG. 4, the electronic device 200 (e.g., the electronic device 200 in FIGS. 2 and 3) may include at least one of a front surface plate 220 (e.g., the front surface plate 202 in FIG. 2), a display 230 (e.g., the display 201 in FIG. 2), a first support member 232 (e.g., a bracket), a printed circuit board 240, a battery 250, a second support member 260 (e.g., a rear case), an antenna 270, and a rear surface plate 280 (e.g., the rear surface plate 211 in FIG. 3). In some embodiments, in the electronic device 200, at least one of the components (e.g., the first support member 232 or the second support member 260) may be omitted, or other components may be additionally included. At least one of the components of the electronic device 200 may be the same as or similar to at least one of the components of the electronic device 200 of FIG. 2 or FIG. 3, and a redundant description thereof will be omitted below.

According to an embodiment, the first support member 232 may be disposed inside the electronic device 200 to be connected to the side surface bezel structure 231, or may be formed integrally with the side surface bezel structure 231. The first support member 232 may be made of, for example, a metal material and/or a non-metal (e.g., polymer) material. The first support member 232 may include one surface to which the display 230 is coupled and the other surface to which the printed circuit board 240 is coupled. A processor, memory, and/or an interface may be mounted on the printed circuit board 240. The processor may include one or more of, for example, a central processing unit, an application processor, a graphics processing unit, an image signal processor, a sensor hub processor, or a communication processor. According to an embodiment, the memory may include, for example, volatile memory or nonvolatile memory. According to an embodiment, the interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector. According to an embodiment, the battery 250 (e.g., the battery 189 in FIG. 1) is a device for supplying power to at least one component (e.g., the camera module 205) of the electronic device 200, and may include, for example, a non-rechargeable primary battery, a rechargeable secondary battery, or a fuel cell. At least a portion of the battery 250 may be disposed to be substantially flush with, for example, the printed circuit board 240. The battery 250 may be integrally disposed inside the electronic device 200, or may be disposed to be detachable from the electronic device 200.

According to various embodiments, the second support member 260 (e.g., the rear case) may be disposed between the printed circuit board 240 and the antenna 270. For example, the second support member 260 may include one surface to which at least one of the printed circuit board 240 or the battery 250 is coupled, and the other surface to which the antenna 270 is coupled.

According to an embodiment, the antenna 270 may be disposed between the rear surface plate 280 and the display 250. The antenna 270 may include, for example, a near-field communication (NFC) antenna, a wireless charging antenna, and/or a magnetic secure transmission (MST) antenna. For example, the antenna 270 may execute short-range communication with an external device or may transmit/receive power required for charging to/from an external device in a wireless manner. For example, the antenna 270 may include a coil for wireless charging. In another embodiment, an antenna structure may be configured by the side surface bezel structure 231 and/or a portion of the first support member 232, or a combination thereof.

According to various embodiments, the electronic device 200 may include a camera module (e.g., the camera module 206 in FIG. 3) disposed inside a housing (e.g., the housing 210 in FIG. 2). According to an embodiment, the camera module 206 may be a rear camera module (e.g., the rear camera module 206 in FIG. 3) disposed on the first support member 232 and configured to acquire an image of a subject located at the rear side (e.g., in the +Z direction) of the electronic device 200. According to an embodiment, at least a portion of the camera module 206 may be exposed to the outside of the electronic device 200 through an opening 282 provided in the rear surface plate 280.

Although the electronic device 200 illustrated in FIGS. 2 to 4 has a bar-type or plate-type appearance, the disclosure is not limited thereto. For example, the illustrated electronic device may be a rollable electronic device or a foldable electronic device. The term "rollable electronic device" may mean an electronic device in which a display (e.g., the display 230 in FIG. 3) is transformable by bending thereby allowing the display to be at least partially wound or rolled or to be accommodated into a housing (e.g., the housing 210 in FIG. 2). According to a user's need, the rollable electronic device may be used in the state in which the screen display area is expanded by unfolding the display or exposing a larger area of the display to the outside. The term "foldable electronic device" may mean an electronic device that is foldable such that two different areas of the display face each other or are oriented in opposite directions. In general, in a foldable electronic device while being carried, the display is folded in the state in which two different areas face each other or are oriented in opposite directions, and in actual use, a user may unfold the display such that the two different areas provide a substantially flat plate shape. In some embodiments, the electronic device 200 according to various embodiments disclosed herein may include not only a portable electronic device such as a smartphone, but also various other electronic devices such as a notebook computer or a camera.

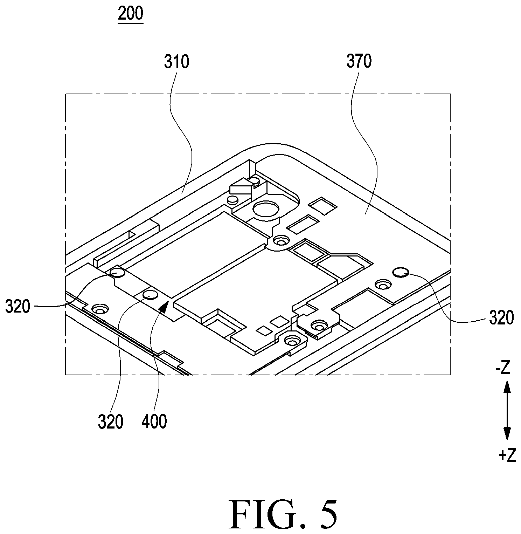

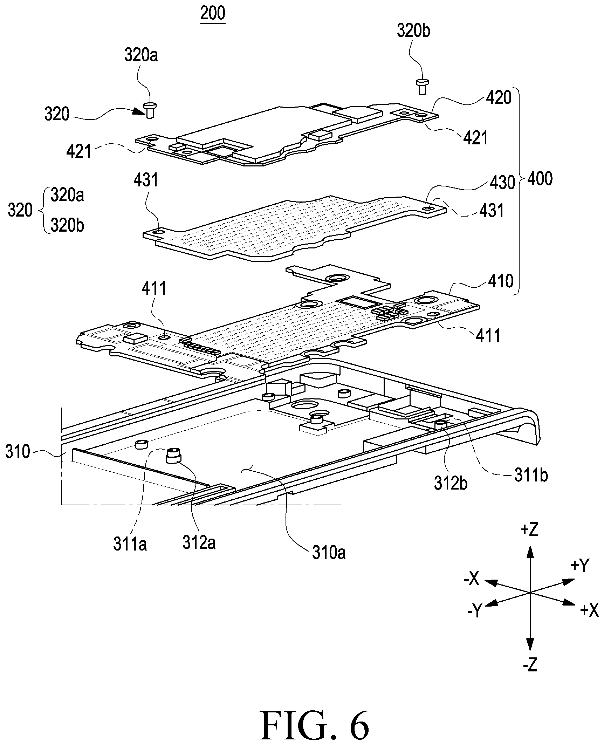

FIG. 5 is a bottom view of an electronic device according to various embodiments of the disclosure in which a rear surface plate (e.g., the rear surface covers 280 and 290 in FIG. 3) is removed. FIG. 6 is an exploded perspective view of the electronic device according to various embodiments of the disclosure.

Referring to FIGS. 5 and 6, the electronic device 200 may include a support member 310, a fastening member 320, and a substrate assembly 400. The configurations of the electronic device 200, the support member 310, and the substrate assembly 400 of FIGS. 5 and 6 may be wholly or partly the same as the configurations of the electronic device 200, the first support member 232, and the substrate unit 240 of FIG. 4.

According to various embodiments, the support member 310 may support the substrate assembly 400. For example, the substrate assembly 400 may be disposed on support member 310. According to an embodiment, the support member 310 may include an inner surface 310a facing at least a portion of the substrate assembly 400 and at least one protruding area 312 extending from the inner surface 310a. At least a portion of the substrate assembly 400 may be disposed on the protruding area 312. According to an embodiment, the protruding area 312 may include a recess (e.g., the recesses 311a and 311b in FIG. 6) that are capable of accommodate at least a portion of the fastening member 320. According to an embodiment, at least a portion of the support member 310 may be interpreted as a ground configured to provide a reference potential to the electronic device 200. For example, at least a portion of the support member 310 may include metal or a conductive material. According to an embodiment, at least a portion of the substrate assembly 400 may be covered by the rear case 370. The rear case 370 may protect the substrate assembly 400. According to an embodiment, the rear case 370 may include metal (e.g., stainless steel).

According to an embodiment, the protruding area 312 may include a plurality of protruding areas 312a and 312b spaced apart from each other. For example, the protruding area 312 may include a first protruding area 312a and a second protruding area 312b spaced apart from the first protruding area 312a. The second protruding area 312b may protrude in a direction substantially parallel to the first protruding area 312a (e.g., the z-axis direction).

According to an embodiment, the recesses 311a and 311b may include a plurality of recesses 311a and 311b spaced apart from each other. For example, the recesses 311a and 311b may include a first recess 311a and a second recess 311b spaced apart from the first recess 31 1a. The second recess 311b may be a groove or a through hole formed in a direction substantially parallel to the first recess 311a. According to an embodiment, the first recess 311a may be provided in the first protruding area 312a, and the second recess 311b may be provided in the second protruding area 312b.

According to various embodiments, the substrate assembly 400 may include a plurality of substrates. According to an embodiment, the substrate assembly 400 may include a first substrate 410, a second substrate 420, and an interposer 430 disposed between the first substrate 410 and the second substrate 420. According to an embodiment, the first substrate 410 and the second substrate 420 may be disposed substantially in parallel to each other. For example, the first substrate 410 and the second substrate 420 may be located along the width (e.g., the XY plane) direction of the electronic device 200. According to an embodiment, the first substrate 410 and/or the second substrate 420 may each be a substrate including at least one layer. For example, the first substrate 410 may be a main (primary) circuit board, and the second substrate 420 may be a secondary circuit board. According to an embodiment, the first substrate 410 may accommodate a processor (e.g., the processor 120 in FIG. 1) and/or a communication module (e.g., the communication module 190 in FIG. 1). According to an embodiment, the substrate assembly 400 may be disposed adjacent to a camera module (e.g., the camera module 180 in FIG. 1 and the camera modules 205 and 206 in FIGS. 2 and 3).

According to various embodiments, the substrate assembly 400 may be connected to the support member 310. According to an embodiment, the substrate assembly 400 may include at least one through hole configured to accommodate the fastening member 320. For example, the first substrate 410 may include first through holes 411, the second substrate 420 may include second through holes 421 corresponding to the first through holes 411, and the interposer 430 may include third through holes 431 corresponding to the first through holes 411 and the second through holes 421. According to an embodiment, the substrate assembly 400 may accommodate electronic components of the electronic device 200. For example, the first substrate 410 or the second substrate 420 may accommodate a processor (e.g., the processor 120 in FIG. 1) and/or a communication module (e.g., the communication module 190 in FIG. 1). According to an embodiment, the interposer 430 may be a substrate that electrically interconnects at least a portion of the first substrate 410 and at least a portion of the second substrate 420.

According to various embodiments, the electronic device 200 may include one or more fastening members 320. According to an embodiment, the fastening members 320 may connect or fasten the substrate assembly 400 to the support member 310. For example, the fastening members 320 may have a screw or boss structure. According to an embodiment, the fastening members 320 may be inserted into through holes in the substrate assembly 400. For example, the fastening members 320 may penetrate the first through holes 411 in the first substrate 410, the second through holes 421 in the second substrate 420, and the third through holes 431 in the interposer 430. According to an embodiment, the fastening members 320 may include a first fastening member 320a at least partially accommodated in a first recess 311a and a second fastening member 320b at least partially accommodated in the second recess 311b.

FIG. 7A is a cross-sectional view of an interposer according to various embodiments of the disclosure, FIG. 7B is a cross-sectional view of an interposer according to another embodiment of the disclosure, FIG. 7C is a cross-sectional view of an interposer according to another embodiment of the disclosure, FIG. 7D is a cross-sectional view of an interposer according to another embodiment of the disclosure, FIG. 7E is a cross-sectional view of an interposer according to another embodiment of the disclosure, and FIG. 7F is a cross-sectional view of an interposer according to another embodiment of the disclosure.

The interposers 430 illustrated in FIGS. 7A, 7B, 7C, 7D, 7E, and 7F may be the same or similar to the interposer 430 illustrated in FIG. 6. Therefore, a description of the same configuration may be omitted.

Referring to FIGS. 7A, 7B, 7C, 7D, 7E, and 7F, according to various embodiments, the interposer 430 may include an interposer substrate 510, an interposer hole 540, a conductor 550, a nonconductor 560, and pre-solder 570.

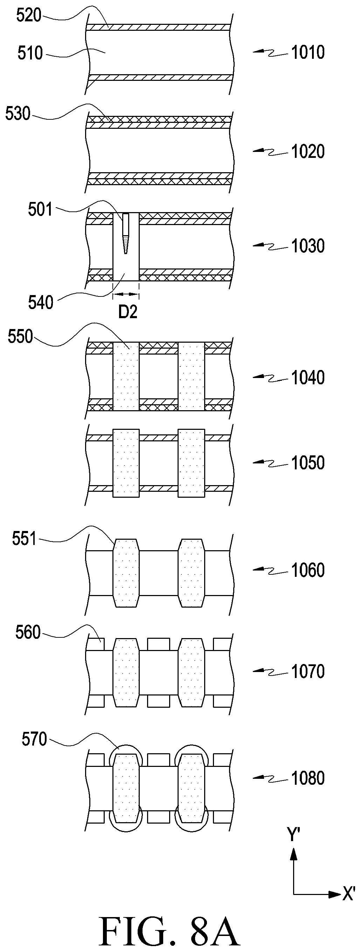

According to various embodiments, the interposer substrate 510 is an insulating layer substrate made of glass fabric and resin, and the cross section of the substrate may have a wavy shape. A plurality of interposer holes 540 may be formed at the interposer substrate 510. The diameter of the interposer holes 540 (see D2 in FIG. 8A) may be about 0.10 mm to about 0.20 mm. The spacing P between first and second centers C1 and C2 of first and second interposer holes 540, which are adjacent to each other among the plurality of interposer holes 540, may be about 0.3 mm to about 0.6 mm. The conductor 550 may be disposed in the interposer holes 540. According to an embodiment, the interposer holes 540 may be filled with the conductor 550. The conductor 550 may be a metal with low resistance. For example, the conductor 550 may be copper (Cu). The conductor 550 is not limited to copper, and other metals may be used. According to an embodiment, the conductor 550 may not be disposed in a direction outside the diameters of the interposer holes 540. For example, the conductor 550 may not be in contact with the outer surface of the interposer substrate 510, or may be disposed such that only a small portion of the conductor 550 is in contact with the outer surface of the interposer substrate 510. The height of the conductor 550 from the interposer substrate 510 may correspond to the height of the nonconductor 560 from the interposer substrate 510.

According to various embodiments, each longitudinal end of the conductor 550 (in the Y'-axis direction) may be formed in various shapes in cross section. According to an embodiment, an inclined surface 551 may be formed at each longitudinal end of the conductor 550. According to an embodiment, the cross-sectional shape of each longitudinal end of the conductor 550 may be a trapezoidal shape. The cross-sectional shape of each longitudinal end of the conductor 550 is not limited to the trapezoidal shape, and may be formed in various shapes. According to another embodiment, irregularities may be formed on the surface of each longitudinal end of the conductor 550. Since each longitudinal end of the conductor 550 is formed in a trapezoidal shape or irregularities are formed on the surface of each longitudinal end, the contact areas with pre-solder 570, which will be described later, increase, thereby increasing bonding strength.

According to various embodiments, the pre-solder 570 may be disposed on the surface of each longitudinal end of the conductor 550. The pre-solder 570 is a type of solder, and may be interpreted as meaning both pre-solder previously disposed on the interposer substrate 510 and solder disposed on the interposer substrate 510 during a later process. The pre-solder 570 is disposed to surround each longitudinal end of the conductor 550, and thus the conductor 550 may not be exposed outside. The pre-solder 570 may be formed in a dome shape. The pre-solder 570 may electrically interconnect the conductor 550 and other components (not illustrated). The pre-solder 570 may fix the conductor 550 and other components (not illustrated) to be interconnected. For example, the other components (not illustrated) may include at least a portion of the first substrate (e.g., the first substrate 410 in FIG. 6) or at least a portion of the second substrate (e.g., the second substrate 420 in FIG. 6). According to an embodiment, the diameter D1 of the pre-solder 570 may be about 0.15 mm to about 0.3 mm.

According to various embodiments, a nonconductor 560 may be disposed between one conductor 550 and another adjacent conductor 550. The nonconductor 560 may be formed of a material that does not conduct electricity. The nonconductor 560 may be disposed on one surface (the +Y'-axis direction) and the other surface (the -Y'-axis direction) of the interposer substrate 510. According to an embodiment, the nonconductor 560 may be disposed on each surface of the interposer substrate 510. The height of the nonconductor 560 from the interposer substrate 510 may correspond to the height of the conductor 550 from the interposer substrate 510.

According to various embodiments, since the spacing P between adjacent interposer holes 540 is about 0.3 mm to about 0.6 mm, more interposer holes 540 may be formed at the interposer 430. Alternatively, when the same interposer holes 540 are formed, the size of the interposer 430 may be downsized.

Referring to FIG. 7B, according to various embodiments, the conductor 550 may include an inclined surface 551 and a vertical surface 552. The vertical surface 552 may be a portion extending in one direction (e.g., the Y'-axis direction) from at least a portion of the conductor 550 provided inside the interposer substrate 510. The inclined surface 551 may be a portion extending from at least a portion of the vertical surface 552 in one direction (e.g., a direction between the X'-axis and Y'-axis).

Referring to FIG. 7B, according to various embodiments, the conductor 550 may include an inclined surface 551, a vertical surface 552, and a horizontal surface 553. The vertical surface 552 may be a portion extending in one direction (e.g., the Y'-axis direction) from at least a portion of the conductor 550 provided inside the interposer substrate 510. The horizontal surface 553 may be a portion extending from at least a portion of the vertical surface 552 in one direction (e.g., the X'-axis direction). The inclined surface 551 may be a portion extending from at least a portion of the horizontal surface 553 in one direction (e.g., a direction between the X'-axis and Y'-axis).

Referring to FIG. 7B, according to various embodiments, the conductor 550 may include an inclined surface 551, a vertical surface 552, and an overlapping surface 554. The overlapping surface 554 may extend from at least a portion of the conductor 550 in one direction (e.g., the X'-axis direction) to be in contact with the interposer substrate 510 or spaced apart from the interposer substrate 510 by a predetermined distance. When the conductor 550 is viewed in a direction substantially parallel to the Y'-axis, the overlapping surface 554 of the conductor 550 and the interposer substrate 510 may overlap each other. The vertical surface 552 may be a portion extending from at least a portion of the overlapping surface 554 in one direction (e.g., the Y'-axis direction). The inclined surface 551 may be a portion extending from at least a portion of the vertical surface 552 in one direction (e.g., a direction between the X'-axis and Y'-axis).

Referring to FIG. 7E, according to various embodiments, the conductor 550 may include an inclined surface 551, a vertical surface 552, a horizontal surface 553, and an overlapping surface 554. The overlapping surface 554 may extend from at least a portion of the conductor 550 in one direction (e.g., the X'-axis direction) to be in contact with the interposer substrate 510 or spaced apart from the interposer substrate 510 by a predetermined distance. When the conductor 550 is viewed in a direction substantially parallel to the Y'-axis, the overlapping surface 554 of the conductor 550 and the interposer substrate 510 may overlap each other. The vertical surface 552 may be a portion extending from at least a portion of the overlapping surface 554 in one direction (e.g., the Y'-axis direction). The horizontal surface 553 may be a portion extending from at least a portion of the vertical surface 552 in one direction (e.g., the X'-axis direction). The inclined surface 551 may be a portion extending from at least a portion of the horizontal surface 553 in one direction (e.g., a direction between the X'-axis and Y'-axis).

Referring to FIG. 7F, according to various embodiments, the conductor 550 may include an inclined surface 551 and a vertical surface 554. The overlapping surface 554 may extend from at least a portion of the conductor 550 in one direction (e.g., the X'-axis direction) to be in contact with the interposer substrate 510 or spaced apart from the interposer substrate 510 by a predetermined distance. When the conductor 550 is viewed in a direction substantially parallel to the Y'-axis, the overlapping surface 554 of the conductor 550 and the interposer substrate 510 may overlap each other. The inclined surface 551 may be a portion extending from at least a portion of the overlapping surface 554 in one direction (e.g., a direction between the X'-axis and Y'-axis).

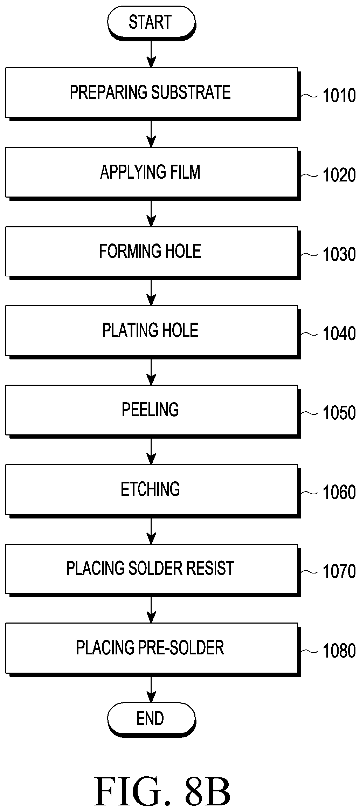

FIGS. 8A and 8B are a schematic view and a flowchart of a process for manufacturing an interposer, according to various embodiments of the disclosure.

The interposer substrate 510, the interposer holes 540, the conductor 550, the inclined surfaces 551, the nonconductor 560, and the pre-solder 570 illustrated in FIGS. 8A and 8B may be the same as or similar to the interposer substrate 510, the interposer holes 540, the conductor 550, the inclined surfaces 551, the nonconductor 560, and the pre-solder 570 illustrated in FIGS. 7A to 7F. Therefore, a description of the same configuration may be omitted.

Referring to FIGS. 8A and 8B, according to various embodiments, the process of manufacturing an interposer (e.g., the interposer 430 in FIGS. 7A to 7F) may include a substrate preparation process (1010), a film application process (1020), a hole forming process (1030), a hole plating process (1040), a peeling process (1050), an etching process (1060), a solder resist placement process (1070), and a pre-solder application process (1080).

According to various embodiments, a conductor foil 520 may be disposed on each surface of the interposer substrate 510. The interposer substrate 510 is an insulating layer substrate made of glass fabric and resin, and the cross section of the substrate may have a wavy shape. The process of manufacturing the interposer 430 may include a substrate preparation process of preparing an interposer substrate 510 having the conductor foil 520 disposed on each surface thereof (1010). The conductor foils 520 may be formed of copper.

According to various embodiments, the process of manufacturing the interposer 430 may include a process of applying a dry film 530 on at least one surface of the conductor foil 520 disposed on each surface of the interposer substrate 510 (1020). The dry film 530 may be a photosensitive dry film.

According to various embodiments, the process of manufacturing the interposer 430 may include a hole forming process of forming a plurality of interposer holes 540 in the interposer substrate 510 on which the dry film 530 is applied by using a drill 501

(1030). The diameter D2 of the interposer holes 540 may be about 0.10 mm to about 0.20 mm. The distance between the centers of first and second interposer holes 540, which are adjacent to each other among the plurality of interposer holes 540, may be about 0.3 mm to about 0.6 mm.

According to various embodiments, the process of manufacturing the interposer 430 may include a hole plating process of plating (filling) the conductor 550 in the interposer holes 540 of the interposer substrate 510 in which the interposer holes 540 are formed (1040). The conductor 550 may be filled in the interposer holes 540 and disposed to be in contact with the conductor foils 520 and the dry film 530. The conductor 550 may be made of metal. According to an embodiment, the conductor 550 may be made of copper (Cu).

According to various embodiments, the process of manufacturing the interposer 430 may include a peeling process of peeling the dry film 530 from the interposer substrate 510 in which the interposer holes 540 are filled with the conductor 550

(1050). Through the peeling process (1050), the dry film 530 disposed on the interposer substrate 510 may be peeled off, and at least a portion of the side surface of the conductor 550 may be exposed outside.

According to various embodiments, the process of manufacturing the interposer 430 may include an etching process of etching the conductor foils 520 and the conductor 550 on the interposer substrate 510 from which the dry film 530 has been peeled (1060). In an embodiment, the etching process (1060) may include a chemical wet etch method. In the etching process (1060), the conductor foils 520 disposed on the interposer substrate 510 may be removed, and the conductor 550 may be at least at least partially removed. As each longitudinal end of the conductor 550 is at least partially removed, an inclined surface 551 may be formed at each longitudinal end of the conductor 550. Accordingly, the cross section of each longitudinal end of the conductor 550 may have a trapezoidal shape. According to another embodiment, irregularities may be formed on the surface of each longitudinal end of the conductor 550. The etching process (1060) may include a process of forming an overlapping surface extending substantially in parallel to the surface of the interposer from the conductor.

According to various embodiments, the process of manufacturing the interposer 430 may include a solder resist placement process in which a nonconductor 560 is disposed on the interposer substrate 510 on which the etching process 1060 has been performed (1070). The nonconductor 560 may be disposed between adjacent ones of the plurality of interposer holes 540. The nonconductor 560 may not conduct electricity and may function as a solder resist. For example, the nonconductor 560 is made of an insulating coating material and photo imageable solder resist (PSR) ink may be used as the nonconductor. According to an embodiment, the nonconductor 560 may be formed through a process of applying solder resist ink and then curing the applied ink by applying ultraviolet (UV) rays to the applied ink, but is not limited thereto.

According to various embodiments, the pre-solder placement process of placing pre-solder 570 on the conductor 550 disposed on the interposer substrate 510 on which the nonconductor 560 is disposed (1080) may be performed. The pre-solder 570 may be made of an electrically conductive material. The pre-solder 570 may be disposed at each longitudinal end of the conductor 550. The pre-solder 570 may be disposed to surround the conductor 550. The pre-solder 570 may be disposed to be in contact with at least a portion of the interposer substrate 510.

According to various embodiments, the spacing P between adjacent ones of the plurality of interposer holes 540 formed at the interposer 430 manufactured through the above process may be about 0.3 mm to about 0.6 mm. As the spacing P of about 0.3 mm to about 0.6 mm is provided, more interposer holes 540 may be formed at the interposer 430 of the same size. Alternatively, when the same number of interposer holes 540 are formed, the size of the interposer 430 may be downsized.

According to various embodiments of the disclosure, an electronic device (e.g., the electronic device 200 in FIG. 2) may include a housing (e.g., the housing 201 in FIG. 2), and a substrate (e.g., the substrate 400 in FIG. 6) disposed inside the housing and including a first substrate (e.g., the first substrate 410 in FIG. 6), a second substrate (e.g., the second substrate 420 in FIG. 6), and an interposer (e.g., the interposer 430 in FIG. 6) disposed between the first substrate and the second substrate. A plurality of interposer holes (e.g., the interposer holes 540 in FIGS. 7A to 7F) may be formed at the interposer, the plurality of interposer holes are filled with a conductor (e.g., the conductor 550 in FIGS. 7A to 7F), a nonconductor (e.g., the nonconductor 560 in FIGS. 7A to 7F) may be disposed on the surface of the interposer between the plurality of interposer holes, and a solder (e.g., the pre-solder 570 in FIGS. 7A to 7F) may be disposed at both ends of the conductor.

According to various embodiments, inclined surfaces (e.g., the inclined surfaces 551 in FIGS. 7A to 7F) may be formed at the side of the both ends of the conductor.

According to various embodiments, the conductor may include an overlapping surface extending in parallel to the surface of the interposer from the conductor.

According to various embodiments, the solder may be disposed to surround the conductor and to be in contact with the surface of the interposer.

According to various embodiments, the height of the conductor from the interposer may correspond to the height of the nonconductor from the interposer.

According to various embodiments, the solder may be disposed to protrude further from the interposer than the nonconductor.

According to various embodiments, the spacing between centers of adjacent ones of the plurality of interposer holes is 0.4 mm or less.

According to various embodiments, the plurality of holes may have a diameter of 0.15 mm to 0.20 mm.

According to various embodiments of the disclosure, a substrate (e.g., the substrate 400 in FIG. 6) may include a first substrate (e.g., the first substrate 410 in FIG. 6), a second substrate (e.g., the second substrate 420 in FIG. 6), and an interposer (e.g., the interposer 430 in FIG. 6) disposed between the first substrate and the second substrate. A plurality of interposer holes (e.g., the interposer holes 540 in FIGS. 7A to 7F) may be formed at the interposer, the plurality of interposer holes are filled with a conductor (e.g., the conductor 550 in FIGS. 7A to 7F), a nonconductor (e.g., the nonconductor 560 in FIGS. 7A to 7F) may be disposed on the surface of the interposer between adjacent ones the plurality of interposer holes, and solder (e.g., the pre-solder 570 in FIGS. 7A to 7F) may be disposed on each end of the conductor.

According to various embodiments, an inclined surface (e.g., the inclined surface 551 in FIGS. 7A to 7F) may be formed on the side surface of each end of the conductor.

According to various embodiments, the conductor may include an overlapping surface extending in parallel to the surface of the interposer from the conductor.

According to various embodiments, the solder may be disposed to surround the conductor and to be in contact with the surface of the interposer.

According to various embodiments, the height of the conductor from the interposer may correspond to the height of the nonconductor from the interposer.

According to various embodiments, the solder may be disposed to protrude further from the interposer than the nonconductor.

According to various embodiments, the spacing between the centers of adjacent ones of the plurality of interposer holes is 0.4 mm or less.

According to various embodiments, the plurality of holes may have a diameter of 0.15 mm to 0.20 mm.

According to various embodiments of the disclosure, a method of manufacturing an interposer may include a process of providing an interposer substrate (e.g., the substrate 510 in FIG. 8A) having a conductor foil (e.g., the conductor foil 520 in FIG. 8) may be disposed on both surfaces thereof (e.g., (1010) in FIGS. 8A and 8B), a process of placing a dry film (e.g., the dry film 530 in FIG. 8A) on the surface of the conductor foil disposed on the both surfaces of the interposer substrate (e.g., (1020) in FIGS. 8A and 8B), a process of forming a plurality of interposer holes (e.g., the interposer holes 540 in FIG. 8A) penetrating the interposer substrate (e.g., (1030) in FIGS. 8A and 8B), a process of plating the interposer holes with a conductor (e.g., the conductor 550 in FIG. 8A) (e.g., (1040) in FIGS. 8A and 8B), a process of peeling off the dry film (e.g., (1050) in FIGS. 8A and 8B), a process of etching to remove the conductor foil and to remove at least a portion of the conductor (e.g., (1060) in FIGS. 8A and 8B), a process of placing a nonconductor (e.g., the nonconductor 560 in FIG. 8A between the interposer holes (e.g., (1070) in FIGS. 8A and 8B), and a process of placing a solder (e.g., the pre-solder in FIGS. 7A to 7F) on both ends of the conductor (e.g., (1080) in FIGS. 8A and 8B).

According to various embodiments, the etching process may include removing at least a portion of the conductor to form an inclined surface (e.g., the inclined surface 551 in FIGS. 7A to 7F) on a side surface of the conductor.

According to various embodiments, the etching process may include forming an overlapping surface extending in parallel to the surface of the interposer from the conductor.

According to various embodiments, the method may further include a process of placing a first substrate (e.g., the first substrate 410 in FIG. 6) on one surface of the interposer substrate and placing a second substrate (e.g., the second substrate 420 in FIG. 6) on the other surface of the interposer substrate.

In the foregoing detailed description of this document, specific embodiments have been described. However, it will be evident to a person ordinarily skilled in the art that various modifications can be made without departing from the scope of the disclosure.

## Claims

1. An electronic device comprising:
a housing; and
a substrate disposed inside the housing and comprising a first substrate, a second substrate, and an interposer disposed between the first substrate and the second substrate,
wherein a plurality of interposer holes are formed at the interposer, the plurality of interposer holes are filled with a conductor, a nonconductor is disposed on a surface of the interposer between the plurality of interposer holes, and a solder is disposed on at both ends of the conductor.

2. The electronic device of claim 1, wherein an inclined surface is formed at a side surface of the both ends of the conductor.

3. The electronic device of claim 1, wherein the conductor comprises an overlapping surface extending parallel to the surface of the interposer.

4. The electronic device of claim 1, wherein the solder is disposed to surround the conductor and to be in contact with the surface of the interposer.

5. The electronic device of claim 1, wherein a height of the conductor from the interposer corresponds to a height of the nonconductor from the interposer.

6. The electronic device of claim 1, wherein the solder is disposed to protrude further from the interposer than the nonconductor.

7. The electronic device of claim 1, wherein a spacing between centers of the plurality of interposer holes is 0.4 mm or less.

8. The electronic device of claim 1, wherein the plurality of holes have a diameter of 0.15 mm to 0.20 mm.

9. A substrate comprising a first substrate, a second substrate, and an interposer disposed between the first substrate and the second substrate,
wherein a plurality of interposer holes are formed at the interposer, the plurality of interposer holes are filled with a conductor, a nonconductor is disposed on a surface of the interposer between the plurality of interposer holes, and a solder is disposed on both ends of the conductor.

10. The substrate of claim 9, wherein an inclined surface is formed at a side surface of the both ends of the conductor.

11. The substrate of claim 9, wherein the conductor comprises an overlapping surface extending parallel to the surface of the interposer.

12. The substrate of claim 9, wherein the solder is disposed to surround the conductor and to be in contact with the surface of the interposer.

13. The substrate of claim 9, wherein a height of the conductor from the interposer corresponds to a height of the nonconductor from the interposer.

14. The substrate of claim 9, wherein the solder is disposed to protrude further from the interposer than the nonconductor.

15. A method of manufacturing an interposer, the method comprising:
providing an interposer substrate, wherein a conductor foil is disposed on both surfaces thereof;
placing a dry film on a surface of the conductor foil disposed on the both surfaces of the interposer substrate;
forming a plurality of interposer holes penetrating the interposer substrate;
plating the interposer holes with a conductor;
peeling off the dry film;
etching to remove the conductor foil and to remove at least a portion of the conductor;
placing a nonconductor between the interposer holes, and
placing a solder on both ends of the conductor.
